# EUROPEAN PATENT APPLICATION

(11) **EP 2 261 007 A1**
(43) Date of publication of application: **15.12.2010**
(21) Application number: 09718005.3
(22) Date of filing: 09.01.2009
(51) Int. Cl.: B29C 59/02, G11B 5/84, G11B 7/26, H01L 21/027, B29L 9/00

(54) **PROCESS FOR PRODUCTION OF NANOSTRUCTURES**

(30) Priority: 03.03.2008 JP 2008052612
(71) Applicant: Daicel Chemical Industries, Ltd., Kita-ku Osaka-shi Osaka 530-0001 (JP)
(72) Inventor: MIYAKE, Hiroto, Himeji-shi Hyogo 671-1283 (JP); IYOSHI, Shuso, Himeji-shi Hyogo 671-1283 (JP)
(74) Representative: Grünecker, Kinkeldey, Stockmair & Schwanhäusser Anwaltssozietät
(86) International application number: PCT/JP2009/000062
(87) International publication number: WO 2009/110162

(57) **Abstract**

Disclosed is a process for the production of a fine structure through nanoimprinting a photocurable resin composition. The process includes the steps of (1) forming a photocurable resin composition for nanoimprint into a film on a support and transferring a pattern to the film by pressing the film with a nanostamper at a pressure of 5 to 100 MPa, in which the photocurable resin composition contains a curable compound component including at least one cationically polymerizable compound and/or at least one free-radically polymerizable compound; and (2) curing the patterned film to obtain the fine structure.

## Description

### Technical Field

The present invention relates to a process for the production of a fine structure by using a fine patterning or fine structuring process, which process is suitable for the formation of a fine pattern highly accurately through nanoimprinting in microlithography. It also relates to a fine structure produced by the process.

### Background Art

The miniaturization of electronic components, for which a resolution down to the range of less than 1 µm is required, has been achieved substantially by photolithographic techniques. To give further smaller structures, miniaturization is being achieved by the progress of ArF lithography and ArF immersion lithography technologies. However, the size of such a small structure of about 32 nm or less approximates to the size of a resin used, and this causes problems such as line edge roughness to come to the surface. On the other hand, the increasingly high requirements with respect to resolution, wall slope, and aspect ratio (ratio of height to resolution) result in a cost explosion in the case of using the apparatuses required for photolithographic structuring, such as masks, mask aligners, and steppers. In particular, owing to their price of several billion yen, latest steppers are a considerable cost factor in microchip production. Independently, there is an attempt to use short-wave radiation, such as electron beams and X-rays, for achieving higher resolution. However, this technique still has many problems from the viewpoint of productivity.

Nanoimprint techniques are expected as an alternative to these techniques. Among the nanoimprint techniques, those mainly known are a thermal nanoimprint technique, in which a thermoplastic resin is heated and softened, then a mold having a predetermined pattern is pressed thereto to form a pattern on the thermoplastic resin; and an ultraviolet nanoimprint technique (UV-nanoimprint technique), in which a photocurable compound is applied to a substrate, and, after the substrate and a mold are pressed together, the resin composition is cured in UV light and becomes solid to give a pattern. Though both of them are excellent techniques, the UV-nanoimprint technique is expected to give a further higher throughput, because this technique employs light to cure the resin and thereby does not need a heating and cooling process in contrast to the thermal nanoimprint technique. In addition to this, the UV-nanoimprint technique has several key features as follows. Specifically, the UV-nanoimprint technique can easily and conveniently give a further higher registration, because it uses a transparent mold. In addition, the UV-nanoimprint technique uses a composition mainly containing liquid monomers in combination and can thereby form a pattern under a very low transfer pressure as compared to that in the thermal nanoimprint technique.

Patent Document 1 describes a nanoimprint process which is based on a thermoplastic deformation of the resist, applied to the whole surface of a substrate, by a relief present on a rigid stamp. Thermoplastics (poly(methyl methacrylate)s, PMMAs) are used as a resist for hot stamping. Owing to common thickness variations of about 100 nm over the total wafer surface, it is not possible to structure 6-, 8-, and 12-inch wafers in one step with a rigid stamp. Thus, a complicated "step and repeat" method would have to be used, which, however, is unsuitable owing to the reheating of already structured neighboring areas.

In Patent Documents 2, Patent Document 3, and Patent Document 4, a stamp is wet with a UV-curable resist (self-assembled monolayer, e.g. alkylsiloxane) and then pressed onto a smooth substrate. Analogously to a common stamp process, the structured resist material remains when the stamp is raised from the substrate surface. The resist materials used sufficiently wet the substrate but are not suitable for a lift-off method, nor do they have sufficient etch resistance. The structure dimensions are in the region of 1 µm and are thus more than one order of magnitude too large.

Patent Document 5 discloses a patterning process using a dry film. This process easily and conveniently gives a pattern with a satisfactory shape at a transfer pressure of 2.5 MPa. However, this process is unsuitable as an alternative for photolithography, because the dry film has a large total thickness of 10 µm or more, and thereby the residual film after transfer (after patterning) has a large thickness.

These processes or techniques are all unsuitable for achieving objects of the present invention as mentioned below.

Patent Document 1: U.S. Patent No. 5,772,905
Patent Document 2: U.S. Patent No. 5,900,160
Patent Document 3: U.S. Patent No. 5,925,259
Patent Document 4: U.S. Patent No. 5,817,242
Patent Document 5: Japanese Unexamined Patent Application Publication (JP-A) No. 2007-73696

### Disclosure of the Invention

### Problems to be Solved by the Invention

An object of the present invention is to provide a process for the production of a fine structure, which process can give a fine structure with an excellent pattern shape with less or no defect and can stably form patterns with small thicknesses of residual films, in which such small residual film thickness are especially important when the process is adopted to lithography.

Another object of the present invention is to provide a fine structure produced by the process for the production of a fine structure.

### Means for Solving the Problems

As a result of intensive investigations, the present inventors have found that the use of a specific transfer resist (nanoimprint resist) under specific transfer conditions stably gives, through a mechanical transfer stamping technique, excellent fine patterns, and the fine patterns have small residual film thickness and show less or no defects such as pattern deformation and pattern missing, even when the technique is adopted to thin films. The present invention has been made based on these findings.

Specifically, the present invention provides a process for production of a fine structure through nanoimprinting a photocurable resin composition. The process includes the steps of (1) forming a photocurable resin composition for nanoimprint into a film on a support (substrate) and transferring a pattern to the film by pressing the film with a nanostamper at a pressure of 5 to 100 MPa, in which the photocurable resin composition contains at least one curable compound component including a cationically polymerizable compound and/or at least one free-radically polymerizable compound; and (2) curing the patterned film to obtain the fine structure.

The present invention further provides a fine structure produced by the production process. Examples of the fine structure include semiconductor materials, flat screens, optical members (diffraction type light-condensing films and polarizing films), holograms, waveguides, structures for media, precision machinery components, and sensors.

As used herein the term "nanoimprint" means and includes not only a regular nanoimprint technique (narrowly-defined nanoimprint) in which a nanostamper is pressed onto a film provided on a support to transfer a pattern to the film, but also a technique of transferring a fine pattern using a mold (broadly-defined nanoimprint) in which a finely patterned mold is used as the nanostamper, a resin composition is poured on the mold, a support is laid thereon, and pressing is performed from the uppermost surface of the resulting laminate.

### Advantages

The process for production of a fine structure of the present invention can give a fine structure with an excellent pattern shape but with less or no defect, by using a cationic curing system and/or free-radical curing system as a resist and transferring a pattern at a pressure in the range of 5 MPa to 100 MPa, in which the resist acts to form fine structures such as semiconductor materials, flat screens, holograms, structures for media, precision machinery components, and sensors.

The process for production of a fine structure of the present invention can stably form a pattern having small residual film thickness, and this feature is important especially when the process is adopted to lithography. The process for production of a fine structure of the present invention is substantially a process for more economically giving a fine structure to an electronic component or the like with low line edge roughness, by employing a photolithography process that gives a high resolution and a satisfactory aspect ratio.

The process for production of a fine structure of the present invention can give a fine structure which excels in pattern accuracy. The resulting fine structure shows pattern deformation and pattern missing at one to ten points, preferably at one point or less on a support film (base film), when a laminate, which comprises the support film and coated film prepared by applying a photocurable resin composition to the support film, is separated (peeled off) from the nanostamper (including a mold) after the completion of curing the photocurable resin composition comprised in the coated film.

### Best Modes for Carrying Out the Invention

The process for production of a fine structure through nanoimprinting on a photocurable resin composition of the present invention comprises the steps of:
(1) forming the photocurable resin composition for nanoimprint into a film on a support and transferring a pattern to the film by pressing the film with a nanostamper at a pressure of 5 to 100 MPa, in which the photocurable resin composition contains a curable compound component including one or more cationically polymerizable compounds and/or one or more free-radically polymerizable compounds; and
(2) curing the patterned film to obtain the fine structure.

### [Step (1)]

The curable compound component may include a cationically photo-curable compound or a free-radically photo-curable compound, or both in combination. Another possible use is the use of a cationically polymerizable compound that is expandable upon curing (has setting expandability) in combination with a compound acting as a radiation-sensitive cationic polymerization initiator, or a compound having both an unsaturated group and an acid group.

### [Cationically Polymerizable Compounds]

Exemplary cationically curable monomers (cationically polymerizable compounds) for use in the cationic curing system include epoxy compounds, vinyl ether compounds, oxetane compounds, carbonate compounds, and dithiocarbonate compounds.

There are known many functional groups that are cationically photo-polymerizable. Among them, for example, epoxy group, vinyl group, and oxetanyl group are highly practicable and widely used.

Exemplary epoxy-containing compounds (epoxy compounds) include alicyclic epoxy resins such as CELLOXIDE 2000, CELLOXIDE 2021, CELLOXIDE 3000, and EHPE 3150CE each supplied by Daicel Chemical Industries, Ltd.; EPOMIK VG-3101 supplied by Mitsui Petrochemical Industries, Ltd. (now part of Mitsui Chemicals Inc.); E-1031S supplied by Yuka Shell Epoxy Kabushiki Kaisha (now part of Mitsubishi Chemical Corporation); TETRAD-X and TETRAD-C each supplied by Mitsubishi Gas Chemical Company, Inc.; and EPB-13 and EPB-27 each supplied by Nippon Soda Co., Ltd. Exemplary epoxy compounds usable herein further include hybrid compounds each having both epoxy group and (meth)acrylic group, such as 3,4-epoxycyclohexylmethyl (meth)acrylates, glycidyl methacrylate, and vinyl glycidyl ether. Each of these compounds can be used alone or in combination.

Vinyl-containing compounds (such as vinyl ether compounds) are not especially limited, as long as being compounds having vinyl group. Exemplary commercially available products of vinyl-containing compounds include 2-hydroxyethyl vinyl ether (HEVE), diethylene glycol monovinyl ether (DEGV), 2-hydroxybutyl vinyl ether (HBVE), and triethylene glycol divinyl ether each supplied by Maruzen Petrochemical Co., Ltd.; and RAPI-CURE Series, V-PYROL (each trademark) (N-vinyl-2-pyrrolidone), and V-CAP^{™} (N-vinyl-2-caprolactam) each supplied by ISP Inc. Exemplary vinyl compounds usable herein further include vinyl compounds each having a substituent such as an alkyl or allyl at the alpha-and/or beta-position; and vinyl ether compounds each containing cyclic ether group such as epoxy group and/or oxetane group, such as oxynorbornene divinyl ether and 3,3-dimethanoloxetane divinyl ether. Exemplary vinyl-containing compounds further include hybrid compounds each having both vinyl group and (meth)acrylic group. Exemplary commercially available products thereof include 2-(2-vinyloxyethoxy)ethyl (meth)acrylates (VEEA and VEEM) supplied by Nippon Shokubai Co., Ltd. Each of these compounds can be used alone or in combination.

The oxetanyl-cotaining compounds (oxetane compounds) are not especially limited, as long as being compounds having oxetanyl group. Exemplary commercially available products thereof include 3-ethyl-3-(phenoxymethyl)oxetane (POX), di[1-ethyl(3-oxetanyl)]methyl ether (DOX), 3-ethyl-3-(2-ethylhexyloxymethyl)oxetane (EHOX), 3-ethyl-3-{[3-(triethoxysilyl)propoxy]methyl}oxetane (TESOX), oxetanylsilsesquioxane (OX-SQ), and phenol novolak oxetane (PNOX-1009) each supplied by Toagosei Co., Ltd. Exemplary oxetanyl-containing compounds usable herein further include hybrid compounds each having both oxetanyl group and (meth)acrylic group, such as 1-ethyl-3-oxetanylmethyl (meth)acrylates. Each of these oxetane compounds may be used alone or in combination.

The carbonate compounds and dithiocarbonate compounds are not especially limited, as long as being compounds each having carbonate group or dithiocarbonate group in the molecule.

### [Setting Expandable, Cationically Polymerizable Compounds]

The photocurable resin composition for use in the present invention preferably further contains a setting-expandable compound as a component, to control its shrinkage on curing to thereby produce a fine structure with an excellent pattern shape. Examples of the cationically polymerizable compound having setting expandability include cyclic ether compounds and carbonate compounds.

Specifically, representative cyclic ether compounds include the following Compound 1, and representative carbonate compounds include the following Compound 2.

Compound 1 is an epoxy compound having a bicyclo ring and represented by following General Formula (1): 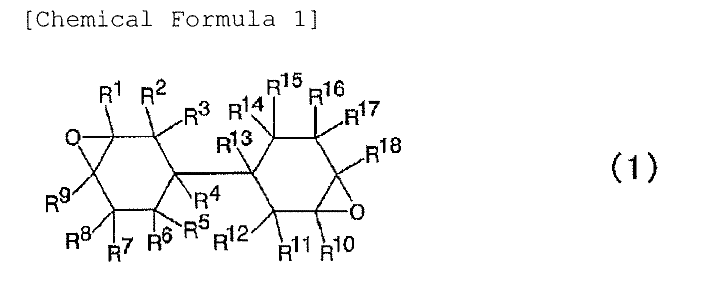 wherein R¹ to R¹⁸ are the same as or different from each other and each represent hydrogen atom, a halogen atom, an alkyl group which may contain oxygen atom or a halogen atom, or a substituted or unsubstituted alkoxy group.

Compound 2 is a carbonate compound represented by following General Formula (2): 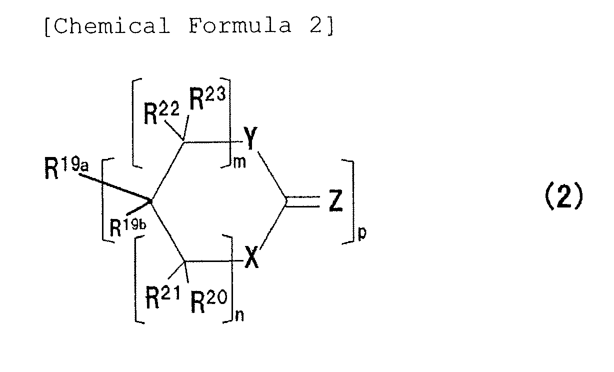 wherein R^{19a} is the same as or different from each other and represents hydrogen atom, a monovalent or multivalent hydrocarbon group having 1 to 10 carbon atoms, a monovalent or multivalent alkyl ester, or a monovalent or multivalent alkyl ether; R^{19b} represents hydrogen atom or an alkyl group; R²⁰ to R²³ are the same as or different from each other and each represent hydrogen atom, a halogen atom, an alkyl group, or an alkoxy group; "p" denotes an integer of 1 to 6; "m" and "n" each denote an integer of 0 to 3; X, Y, and Z each represent oxygen atom or sulfur atom, wherein, when "p" is 1, R^{19a} represents hydrogen atom or a monovalent alkyl group having 1 to 10 carbon atoms, a monovalent alkyl ester, or a monovalent alkyl ether; and when "p" is 2 or more, R^{19a} represents a single bond, a hydrocarbon group having a valency of "p", an alkyl group having a valency of "p", or an alkoxy group having a valency of "p".

Each of the compounds preferably has a structure containing the cationically photo-polymerizable functional group. The coexistence of the compound having both reactivity and expandability in the system gives an ideal photocurable composition for nanoimprint, whose shrinkage on curing is controlled, and which does not undergo volumetric shrinkage on curing.

### [Free-Radically Polymerizable Compounds]

Exemplary free-radically curable monomers (free-radically polymerizable compounds) usable in the free-radical curing system (free-radical polymerization system) include (meth)acrylic ester compounds, styrenic compounds, acrylic silane compounds, and multifunctional monomers.

Exemplary (meth)acrylic ester compounds include alkyl (meth)acrylates such as methyl (meth)acrylates, ethyl (meth)acrylates, propyl (meth)acrylates, butyl (meth)acrylates, pentyl (meth)acrylates, and hexyl (meth)acrylates; hydroxyl-containing (meth)acrylic esters such as 2-hydroxyethyl (meth)acrylates, hydroxypropyl (meth)acrylates, hydroxybutyl (meth)acrylates, and caprolactone-modified 2-hydroxyethyl (meth)acrylates; and other (meth)acrylates such as methoxydiethylene glycol (meth)acrylates, ethoxydiethylene glycol (meth)acrylates, isooctyloxydiethylene glycol (meth)acrylates, phenoxytriethylene glycol (meth)acrylates, methoxytriethylene glycol (meth)acrylates, and methoxypolyethylene glycol (meth)acrylates.

Exemplary styrenic compounds include styrene and methylstyrene.

Exemplary acrylic silane compounds include γ-acryloxypropyltrimethoxysilane, γ-acryloxypropyltriethoxysilane, γ-acryloxypropylmethyldimethoxysilane, γ-acryloxypropylmethyldiethoxysilane, acryloxyethoxypropyltrimethoxysilane, acryloxyethoxypropyltriethoxysilane, acryloxydiethoxypropyltrimethoxysilane, and acryloxydiethoxypropyltriethoxysilane.

Exemplary multifunctional monomers include diethylene glycol diacrylate, triethylene glycol diacrylate, tetraethylene glycol diacrylate, polyethylene glycol diacrylates, polyurethane diacrylates, trimethylolpropane triacrylate, pentaerythritol triacrylate, pentaerythritol tetraacrylate, trimethylolpropane ethylene oxide-modified triacrylate, trimethylolpropane propylene oxide-modified triacrylate, dipentaerythritol pentaacrylate, and dipentaerythritol hexaacrylate; methacrylates corresponding to these acrylates; and mono-, di-, tri- or higher polyesters of a polybasic acid and a hydroxyalkyl (meth)acrylate. Each of these can be used alone or in combination.

### [Compounds Having Both Unsaturated Group and Acid Group]

Examples of the free-radically polymerizable compounds for use herein further include compounds each having both a free-radically polymerizable unsaturated group and at least one acid group. Specifically, examples of such compounds include (meth)acrylic acids; vinylphenols; modified unsaturated monocarboxylic acids whose carboxylic acid moiety being bonded to an unsaturated group with the interposition of an extended chain, including unsaturated monocarboxylic acids having an ester bond, such as β-carboxyethyl (meth)acrylates, 2-acryloyloxyethylsuccinic acid, 2-acryloyloxyethylphthalic acid, 2-acryloyloxyethylhexahydrophthalic acid, lactone-modified compounds and other unsaturated monocarboxylic acids having an ester bond, and modified unsaturated monocarboxylic acids having an ether bond; and compounds each having two or more carboxyl groups per molecule, such as maleic acid. Each of these compounds may be used alone or in combination. Among them, especially preferred are modified unsaturated monocarboxylic acids whose carboxylic acid moiety being bonded to an unsaturated group with the interposition of an extended chain of lactone.

Specific examples thereof include Compound 3 and Compound 4 represented by following Formulae (3) and (4).

Compound 3 is a lactone-modified (meth)acrylic acid and is a compound represented by following General Formula (3): 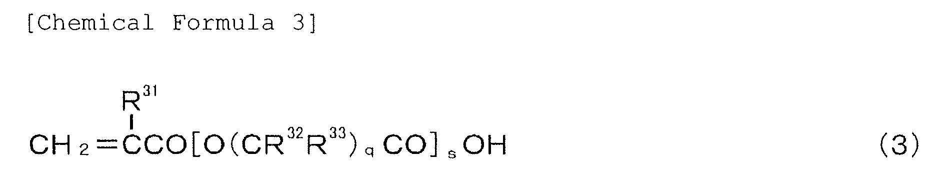 wherein R³¹ represents hydrogen atom or methyl group; R³² and R³³ independently represent hydrogen atom, methyl group, or ethyl group; "q" denotes an integer of 4 to 8; and "s" denotes an integer of 1 to 10.

Compound 4 is a lactone-modified compound whose terminal hydroxyl group is acid-modified with an acid anhydride and is represented by following General Formula (4) : 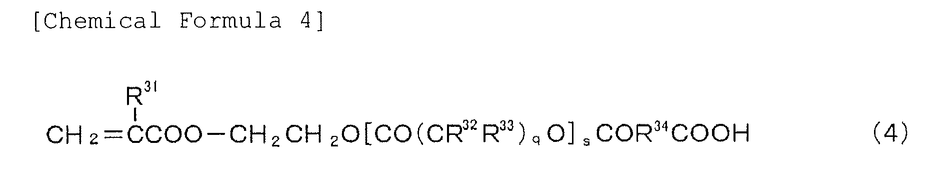 wherein R³¹, R³², and R³³ are as defined above; R³⁴ represents, for example, a bivalent aliphatic saturated or unsaturated hydrocarbon group having 1 to 10 carbon atoms, a bivalent alicyclic saturated or unsaturated hydrocarbon group having 3 to 6 carbon atoms, p-xylene, or phenylene group; and "q" and "s" are as defined above. Specific examples thereof include β-CEA supplied by Daicel-Cytec Co., Ltd.; Aronix M5300 supplied by Toagosei Co., Ltd.; and PLACCEL FA Series supplied by Daicel Chemical Industries, Ltd.

### [Preferred Embodiments of Photocurable Resin Composition]

(i) In a preferred embodiment, the photocurable resin composition for nanoimprint for use in the process for production of a fine structure of the present invention contains at least a setting-expandable, cationically polymerizable compound (for example, any of compounds represented by Formulae (1) and (2)) as a cationically polymerizable compound. The content of the compound is typically 1 to 80 parts by weight, preferably 5 to 70 parts by weight, more preferably 10 to 60 parts by weight, and especially preferably 25 to 50 parts by weight, per 100 parts by weight of the total amount of cationically polymerizable compounds. The photocurable resin composition according to this embodiment helps to further suppress shrinkage on curing and thereby gives a fine structure with an excellent pattern shape.

(ii) In another preferred embodiment, the photocurable resin composition for nanoimprint for use in the process for production of a fine structure of the present invention contains, as cationically polymerizable compounds, at least one epoxy compound and at least one compound selected from the group consisting of vinyl ether compounds and oxetane compounds. The ratio of the epoxy compound (former) to the at least one compound selected from the group consisting of vinyl ether compounds and oxetane compounds (latter) [former/latter] (ratio by weight) is typically from 20/80 to 99/1, preferably from 30/70 to 95/5, and more preferably from 40/60 to 90/10. The photocurable resin composition according to this embodiment shows a further higher reaction rate, is curable even upon exposure to weak light, and thereby gives a fine structure with an excellent pattern shape at a high throughput.

(iii) In yet another preferred embodiment, the photocurable resin composition for nanoimprint for use in the process for production of a fine structure of the present invention contains a compound having both an unsaturated group and an acid group as a free-radically polymerizable compound. The content of this compound is typically 1 to 50 parts by weight, preferably 2 to 40 parts by weight, and more preferably 2 to 15 parts by weight, per 100 parts by weight of the total amount of free-radically polymerizable compounds. The introduction of the acid group improves adhesion with the substrate and thereby gives a pattern with an excellent shape on the substrate. Additionally, this enables cleaning with an alkali (base) when the nanomold is contaminated by the curable resin.

(vi) In still another preferred embodiment, the photocurable resin composition for nanoimprint for use in the process for production of a fine structure of the present invention contains both a cationically polymerizable compound and a free-radically polymerizable compound. The ratio of the cationically polymerizable compound (former) to the free-radically polymerizable compound (latter) [former/latter] (ratio by weight) is typically from 1/99 to 99/1, preferably from 10/90 to 95/5, and more preferably from 30/70 to 90/10. The photocurable resin composition according to this embodiment helps to further suppress the shrinkage on curing and thereby gives a fine structure with an excellent pattern shape.

The photocurable resin composition can be advantageously used in microlithography. Specifically, a fine structure having an excellent pattern shape with high accuracy can be obtained by pressing a nanostamper to a film of the photocurable resin composition at a pressure in the range of, for example, 5 to 100 MPa, preferably 10 to 100 MPa, and especially preferably more than 10 MPa and 100 MPa or less to transfer a pattern. If the nanostamper is pressed to the film of the resin composition at a pressure less than 5 MPa to transfer the pattern, the pattern may not be transferred sufficiently accurately.

### [Binder Resins]

Binder resins are usable in the photocurable resin composition. Examples of such binder resins include poly(methacrylic ester)s or partially hydrolyzed products thereof; poly(vinyl acetate)s or hydrolyzed products thereof; poly(vinyl alcohol)s or partially acetalized products thereof; triacetylcellulose; polyisoprenes; polybutadienes; polychloroprenes; silicone rubbers; polystyrenes; poly(vinyl butyral)s; polychloroprenes; poly(vinyl chloride)s; polyarylates; chlorinated polyethylenes; chlorinated polypropylenes; poly-N-vinylcarbazoles or derivatives thereof; poly-N-vinylpyrrolidones or derivatives thereof; copolymers of styrene and maleic anhydride, or semiesters thereof; copolymers each having, as polymerization component (monomer component), at least one selected from the group consisting of copolymerizable monomers such as acrylic acid, acrylic ester, methacrylic acid, methacrylic ester, acrylamide, acrylonitrile, ethylene, propylene, vinyl chloride, and vinyl acetate; and mixtures of them.

Exemplary binder resins usable herein further include curable resins of oligomer type, including unsaturated-group-containing epoxidized resins such as epoxidized polybutadienes and epoxidized butadiene-styrene block copolymers. Exemplary commercially available products thereof include EPOLEAD PB and ESBS each supplied by Daicel Chemical Industries, Ltd.

Copolymerized epoxy resins are also advantageous as binder resins. Examples thereof include copolymers of glycidyl methacrylate and styrene; copolymers of glycidyl methacrylate, styrene, and methyl methacrylate (e.g., CP-50M and CP-50S each supplied by NOF Corporation); and copolymers typically between glycidyl methacrylate and cyclohexylmaleimide.

Exemplary binder resins further include polymers each containing one or more cationically curable resins having special structures (e.g., 3,4-epoxycyclohexylmethyl (meth)acrylates, 1-ethyl-3-oxetanylmethyl (meth)acrylates, and 2-(2-vinyloxyethoxy)ethyl (meth)acrylates). Examples of the polymers include copolymers of 3,4-epoxycyclohexylmethyl (meth)acrylate and styrene; copolymers of 3,4-epoxycyclohexyl (meth)acrylate and butyl acrylate;
copolymers of 3,4-epoxycyclohexylmethyl (meth)acrylate, styrene, and methyl methacrylate (e.g., CELTOP supplied by Daicel Chemical Industries, Ltd.); and copolymers of 3,4-epoxycyclohexylmethyl (meth)acrylate and 1-ethyl-3-oxetanylmethyl (meth)acrylate.

Exemplary binder resins usable herein still further include novolak epoxy resins which are reaction products of a novolak with epichlorohydrin and/or methylepichlorohydrin, which novolak is prepared by reacting a phenol (e.g., phenol, cresol, a halogenated phenol, or an alkylphenol) with formaldehyde in the presence of an acidic catalyst. Exemplary commercially available products of such novolak epoxy resins include EOCN-103, EOCN-104S, EOCN-1020, EOCN-1027, EPPN-201, and BREN-S each supplied by Nippon Kayaku Co., Ltd.; DEN-431 and DEN-439 each supplied by The Dow Chemical Company; and N-73 and VH-4150 each supplied by DIC Corporation.

Exemplary binder resins usable herein further include bisphenol epoxy resins such as reaction products between epichlorohydrin and a bisphenol (e.g., bisphenol-A, bisphenol-F, bisphenol-S, or tetrabromobisphenol-A); and reaction products among diglycidyl ether of bisphenol-A, a condensate of the bisphenol, and epichlorohydrin. Exemplary commercially available products of such bisphenol epoxy resins include EPIKOTE (former name for jER) 1004 and EPIKOTE (former name for jER) 1002 each supplied by Yuka Shell Epoxy Kabushiki Kaisha (now part of Mitsubishi Chemical Corporation); and DER-330 and DER-337 each supplied by The Dow Chemical Company.

Exemplary binder resins usable herein further include reaction products typically of trisphenolmethane or triscresolmethane with epichlorohydrin and/or methylepichlorohydrin. Exemplary commercially available products thereof include EPPN-501 and EPPN-502 each supplied by Nippon Kayaku Co., Ltd. Examples of binder resins further include tris(2,3-epoxypropyl) isocyanurate and biphenyl diglycidyl ether. Each of these epoxy resins may be used alone or in combination.

The amount of binder resins is typically 0 to 100 parts by weight (e.g., about 1 to 100 parts by weight), preferably 3 to 80 parts by weight, and more preferably 5 to 40 parts by weight, per 100 parts by weight of the total amount of curable compounds.

### [Radiation-Sensitive Cationic Polymerization Initiators]

The photocurable resin composition for use in the present invention may further contain one or more radiation-sensitive cationic polymerization initiators. Though not especialy limited, as long as being a known cationic polymerization initiator that generates an acid through the action of active energy rays, examples of the radiation-sensitive cationic polymerization initiator include sulfonium salts, iodonium salts, phosphonium salts, and pyridinium salts.

Exemplary sulfonium salts include triphenylsulfonium hexafluorophosphate, triphenylsulfonium hexafluoroantimonate, bis(4-(diphenylsulfonio)-phenyl)sulfide bis(hexafluorophosphate), bis(4-(diphenylsulfonio)-phenyl)sulfide bis(hexafluoroantimonate), 4-di(p-toluyl)sulfonio-4'-tert-butylphenylcarbonyl-diphenylsulfide hexafluoroantimonate, 7-di(p-toluyl)sulfonio-2-isopropylthioxanthone hexafluorophosphate, 7-di(p-toluyl)sulfonio-2-isopropylthioxanthone hexafluoroantimonate, and aromatic sulfonium salts described typically in Japanese Unexamined Patent Application Publication (JP-A) No. H06(1994)-184170, Japanese Unexamined Patent Application Publication (JP-A) No. H07(1995)-61964, Japanese Unexamined Patent Application Publication (JP-A) No. H08(1996)-165290, and U.S. Patent Nos. 4231951 and 4256828.

Exemplary iodonium salts include diphenyliodonium hexafluorophosphate, diphenyliodonium hexafluoroantimonate, bis(dodecylphenyl)iodonium tetrakis(pentafluorophenyl)borate, and aromatic iodonium salts described typically in Japanese Unexamined Patent Application Publication (JP-A) No. H06(1994)-184170 and U.S. Patent No. 4256828.

Exemplary phosphonium salts include tetrafluorophosphonium hexafluorophosphate, tetrafluorophosphonium hexafluoroantimonate, and aromatic phosphonium salts described typically in Japanese Unexamined Patent Application Publication (JP-A) No. H06(1994)-157624.

Exemplary pyridinium salts include pyridinium salts described typically in Japanese Patent No. 2519480 and Japanese Unexamined Patent Application Publication (JP-A) No. H05(1993)-222112.

For further higher reactivity, the anion constituting the radiation-sensitive cationic polymerization initiator is preferably SbF⁶⁻, or a borate (Compound 5) represented by following Formula (5): 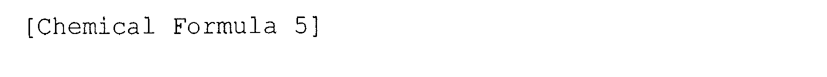 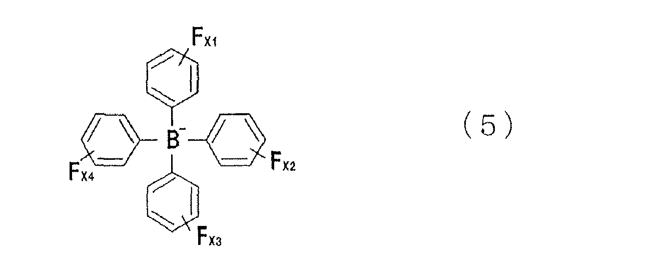 wherein each of X1, X2, X3, and X4 represents an integer of 0 to 5, and the total of X1, X2, X3, and X4 is 1 or more. Of the borates, tetrakis(pentafluorophenyl)borate is more preferred.

Such sulfonium salts and iodonium salts are easily commercially available. Examples of such easily commercially available radiation-sensitive cationic polymerization initiators include sulfonium salts such as UVI-6990 and UVI-6974 each supplied by Union Carbide Corporation (subsidiary of The Dow Chemical Company), and ADEKA OPTOMER SP-170 and ADEKA OPTOMER SP-172 each supplied by ADEKA CORPORATION; and iodonium salts such as PI 2074 supplied by Rhodia.

Though not critical, the amount of such radiation-sensitive cationic polymerization initiators is preferably 0.1 to 15 parts by weight and more preferably 1 to 12 parts by weight, per 100 parts by weight of the cationically curable polymer.

### [Radiation-Sensitive Free-Radical Polymerization Initiator]

The photocurable resin composition for use in the present invention may further contain one or more radiation-sensitive free-radical polymerization initiators. Exemplary radiation-sensitive free-radical polymerization initiators include known or common photoinitiators including benzoin and benzoin alkyl ethers, such as benzoin, benzoin methyl ether, benzoin ethyl ether, and benzoin isopropyl ether; acetophenones such as acetophenone, 2,2-dimethoxy-2-phenylacetophenone, 2,2-diethoxy-2-phenylacetophenone, 1,1-dichloroacetophenone, 2-methyl-1-[4-(methylthio)phenyl]-2-morpholino-propan-1-one, and 2-benzyl-2-dimethylamino-1-(4-morpholinophenyl)-butan-1-one; anthraquinones such as 2-methylanthraquinone, 2-ethylanthraquinone, 2-tert-butylanthraquinone, 1-chloroanthraquinone, and 2-amylanthraquinone; thioxanthones such as 2,4-dimethylthioxanthone, 2,4-diethylthioxanthone, 2-chlorothioxanthone, and 2,4-isopropylthioxanthone; ketals such as acetophenone dimethyl ketal, and benzil dimethyl ketal; benzophenones such as benzophenone; xanthones; and 1,7-bis(9-acridinyl)heptane. Each of different photoinitiators can be used alone or in combination.

Each of these photoinitiators can be used in combination with one or more known or common photosensitizers. Exemplary photosensitizers include tertiary amines such as ethyl N,N-dimethylaminobenzoate, isoamyl N,N-dimethylaminobenzoate, pentyl 4-dimethylaminobenzoate, triethylamine, and triethanolamine.

Exemplary commercially available initiators include Irgacure (registered trademark) 184 (1-hydroxycyclohexyl phenyl ketone), Irgacure (registered trademark) 500 (mixture of 1-hydroxycyclohexyl phenyl ketone and benzophenone), and other Irgacure (registered trademark) type photoinitiators each available from Ciba (now part of BASF); and Darocur (registered trademark) 1173, 1116, 1398, 1174, and 1020 each available from Merck. One or more thermal initiators can be used in combination with the photoinitiator(s). Exemplary suitable thermal initiators include organic peroxides, of which more suitable are those in the form of diacyl peroxides, peroxydicarbonates, alkyl peresters, dialkyl peroxides, perketals, ketone peroxides, and alkyl hydroperoxides. Specific examples of such thermal initiators include dibenzoyl peroxide, t-butyl perbenzoate, and azobisisobutyronitrile.

### [Sensitizers and Sensitizing Dyes]

The photocurable resin composition for use in the present invention may further contain one or more sensitizers. Exemplary sensitizers usable herein include anthracene, phenothiazene, perylene, thioxanthone, and benzophenone/thioxanthone. Exemplary sensitizers further include sensitizing dyes such as thiopyrylium salt dyes, merocyanine sensitized dyes, quinoline dyes, styrylquinoline dyes, ketocoumarin dyes, thioxanthene dyes, xanthene dyes, oxonol dyes, cyanine dyes, rhodamine dyes, and pyrylium salt dyes.

Among them, especially preferred are anthracene sensitizers. Such an anthracene sensitizer, when used in combination with a cationic curing catalyst (radiation-sensitive cationic polymerization initiator), helps the resin composition to have a dramatically improved sensitivity. In addition, the anthracene sensitizer has also a free-radical polymerization initiating function and thereby simplifies the catalyst species when used in a hybrid catalyst system using a cationic curing system and a free-radical curing system in combination and adopted in an embodiment of the present invention. Specific examples of anthracene compounds effective herein include dibutoxyanthracene and dipropoxyanthraquinone (Anthracure (trademark) UVS-1331 and Anthracure (trademark) UVS-1221 each supplied by Kawasaki Kasei Chemicals Ltd.).

The amount of sensitizers is typically 0.01 to 20 parts by weight and preferably 0.01 to 10 parts by weight, per 100 parts by weight of curable monomers.

### [Nanoscale Particles]

The photocurable resin composition for use in the present invention may further contain nanoscale particles (nanoparticles) according to necessity. Exemplary nanoscale particles usable herein include polymerizable silanes such as a compound (Compound 6) represented by following Formula (6):

SiU₄ (6)

wherein the groups Us are the same as or different from each other and represent hydrolyzable groups or hydroxyl groups; and a compound (Compound 7) represented by following Formula (7) :

R⁴¹ₐR⁴²_{b}SiU_{(4-a-b)} (7)

wherein R⁴¹ represents a nonhydrolyzable group; R⁴² represents a group containing a functional group; Us are as defined above; and "a" and "b" each denote a value of 0, 1, 2, or 3, and the total of "a" and "b" (a+b) denotes a value of 1, 2, or 3. Exemplary nanoscale particles further include condensates derived from such polymerizable silanes.

Exemplary nanoscale particles further include nanoscale particles selected from the group consisting of oxides, sulfides, selenides, tellurides, halides, carbides, arsenides, antimonides, nitrides, phosphides, carbonates, carboxylates, phosphates, sulfates, silicates, titanates, zirconates, aluminates, stannates, plumbates, and mixed oxides thereof.

The volume fraction (content) of nanoscale particles added according to necessity in the photocurable resin composition for nanoimprint is typically 0 to 50 percent by volume, preferably 0 to 30 percent by volume, and especially preferably 0 to 20 percent by volume, based on the total amount of the photocurable resin composition.

The nanoscale particles have a particle size (particle diameter) of generally about 1 to 200 nm, preferably about 2 to 50 nm, and especially preferably about 2 to 20 nm.

Nanoscale inorganic particles such as those known from PCT International Publication Number WO 96/31572 include, for example, oxides such as CaO, ZnO, CdO, SiO₂, TiO₂, ZrO₂, CeO₂, SnO₂, PbO, Al₂O₃, In₂O₃, and La₂O₃; sulfides such as CdS and ZnS; selenides such as GaSe, CdSe, and ZnSe; tellurides such as ZnTe and CdTe; halides such as NaCl, KCl, BaCl₂, AgCl, AgBr, AgI, CuCl, CuBr, CdI₂, and PbI₂; carbides such as CeC₂; arsenides such as AlAs, GaAs, and CeAs; antimonides such as InSb; nitrides such as BN, AlN, Si₃N₄, and Ti₃N₄; phosphides such as GaP, InP, Zn₃P₂, and Cd₃P₂; carbonates such as Na₂CO₃, K₂CO₃, CaCO₃, SrCO₃, and BaCO₃; carboxylates including acetates such as CH₃COONa and Pb(CH₃COO)₄; phosphates; sulfates; silicates; titanates; zirconates; aluminates; stannates; plumbates; and corresponding mixed oxides which is preferably identical in composition with common glasses having a low coefficient of thermal expansion, e.g. binary, tertiary, or quaternary combinations of SiO₂, TiO₂, ZrO₂, and Al₂O₃.

These nanoscale particles can be prepared according to a known process, such as flame hydrolysis, flame pyrolysis and plasma processes according to the literatures described in PCT International Publication Number WO 96/31572. Among such nanoscale particles, especially preferred are stabilized colloidal, nanodisperse sols of inorganic particles, such as silica sols supplied by BAYER, SnO₂ sols supplied by Goldschmidt, TiO₂ sols supplied by Merck, SiO₂, ZrO₂, Al₂O₃, and Sb₂O₃ sols supplied by Nissan Chemicals, and aerosil dispersions supplied by Degussa.

In a preferred embodiment, the photocurable resin composition for nanoimprint further contains a fluorosilane (Compound 8) represented by following Formula (8):

R⁴³(U¹)₃Si (8)

wherein R⁴³ is a partially fluorinated or perfluorinated alkyl having 2 to 20 carbon atoms; and U¹ is an alkoxy having 1 to 3 carbon atoms, methyl, ethyl group, or chlorine.

Partially fluorinated alkyl is understood as meaning those alkyl groups in which at least one hydrogen atom is replaced by a fluorine atom.
Preferred examples of the group R⁴³ include CF₃CH₂CH₂, C₂F₅CH₂CH₂, C₄F₉CH₂CH₂, n-C₆F₁₃CH₂CH₂, n-C₈F₁₇CH₂CH₂, n-C₁₀F₂₁CH₂CH₂, and i-C₃F₇O-(CH₂)₃.

Examples of fluorosilanes of Formula (8), which are also commercially available, include tridecafluoro-1,1,2,2-tetrahydrooctyl-1-triethoxysilane, CF₃CH₂CH₂SiCl₂CH₃, CF₃CH₂CH₂SiCl(CH₃)₂, CF₃CH₂CH₂Si(CH₃)(OCH₃)₂, i-C₃F₇O-(CH₂)₃SiCl₂CH₃, n-C₆F₁₃CH₂CH₂SiCl₂CH₃, and n-C₆F₁₃CH₂CH₂SiCl (CH₃)₂.

The fluorosilanes of Formula (8) can be present in an amount of, for example, 0 to 3 percent by weight, preferably 0.05 to 3 percent by weight, more preferably 0.1 to 2.5 percent by weight, and especially preferably 0.2 to 2 percent by weight, based on the total weight of the photocurable resin composition for nanoimprint. The presence of fluorosilanes is desirable in particularly when a glass or silica glass stamp is used as the transfer imprint stamp (nanostamper).

### [Support]

In Step (1), exemplary materials for the support (substrate) to which the resin composition is applied include glass, silica glass, films, plastics, and silicon wafers. The support may have an adhesion-promoting film on its surface. The adhesion-promoting film can be formed from organic polymers which wet the support enough. Exemplary organic polymers for the formation of the adhesion-promoting film include polymers or copolymers containing aromatic compounds, which have novolaks, styrenes, (poly)hydroxystyrenes, and/or (meth)acrylates. The adhesion-promoting film can be formed by applying a solution containing the organic polymer to a support according to a known procedure such as spin coating.

### [Solvent]

The photocurable resin composition for nanoimprint can be applied either in itself or as a solution in an organic solvent. The organic solvent for use in the composition herein is used in the following manner. The composition is diluted with the solvent to form a paste, the resulting paste can be easily applied, the applied composition is dried to form a film, and the film can undergo contact exposure. Exemplary solvents include ketones such as methyl ethyl ketone and cyclohexanone; aromatic hydrocarbons such as toluene, xylenes, and tetramethylbenzene; glycol ethers such as Cellosolve, methyl Cellosolve, Carbitol, methyl Carbitol, butyl Carbitol, propylene glycol monomethyl ether, dipropylene glycol monomethyl ether, dipropylene glycol monoethyl ether, and triethylene glycol monoethyl ether; acetic esters such as ethyl acetate, butyl acetate, Cellosolve acetate, butyl Cellosolve acetate, Carbitol acetate, butyl Carbitol acetate, and propylene glycol monomethyl ether acetate; alcohols such as ethanol, propanol, ethylene glycol, and propylene glycol; aliphatic hydrocarbons such as octane and decane; petroleum solvents such as petroleum ethers, petroleum naphthas, hydrogenated petroleum naphthas, and solvent naphthas. Each of these solvents can be used alone or in combination.

In Step (1), the photocurable resin composition for nanoimprint is applied as a film by applying the resin composition to a support by a known procedure such as spin coating, slit coating, spray coating, or roller coating. The viscosity of the film (resin composition upon application) is preferably about 1 mpa·s to 10 Pa·s, more preferably about 5 mPa·s to 5 Pa·s, and especially preferably about 5 mPa·s to 1000 mPa·s. The thickness of the film from the photocurable resin composition for nanoimprint (film before transfer) formed by the above process (narrowly-defined nanoimprint) is typically about 50 to 1000 nm, and preferably about 100 to 500 nm.

In stead of the above-mentioned process (narrowly-defined nanoimprint), Step (1) can employ another process (broadly-defined nanoimprint) for the formation of the film from the photocurable resin composition for nanoimprint, in which the resin composition is poured onto a mold, a support is laid thereover, and pressing is performed from the topmost surface of the laminate. This process may be adopted particularly to the production of diffraction type light-condensing films. The thickness of the film from the photocurable resin composition for nanoimprint (film before transfer) formed by the process (broadly-defined nanoimprint) is typically about 0.1 µm to 10 mm, and preferably about 1 µm to 1 mm.

### [Nanostamper]

The nanostamper for use in Step (1) is a nanoimprint transfer stamp having a transfer pattern with projections and depressions on its surface. Exemplary materials for the nanostamper include transparent Teflon (registered trademark) resins, silicone rubbers, cycloolefin polymer resins, glass, quartz, silica glass, and Ni-P. Among them, a silicone rubber is advantageous for the stamper, because such silicon rubber stamper can be satisfactorily removed from the resin after pattern transfer even when the resin composition does not contain the fluorosilane of Formula (8). Alternatively, a finely patterned mold can also be used as the nanostamper in the present invention.

The pattern transfer in Step (1) is performed by pressing the nanostamper placed on the film at a pressure of, for example, 5 to 100 MPa, preferably 10 to 100 MPa, and more preferably more than 10 MPa and 100 MPa or less for a duration of, for example, about 0.1 to 300 seconds, preferably about 0.2 to 100 seconds, and especially preferably about 0.5 to 30 seconds. The thickness of the film after pattern transfer (before curing) is typically about 50 to 1000 nm, and preferably about 100 to 500 nm. When used in the production of diffraction type light-condensing films, the thickness of the film after pattern transfer (before curing) is typically about 0.1 µm to 10 mm, and preferably about 1 µm to 1 mm.

In narrowly-defined nanoimprint, if the transfer is performed at a pressure of less than 5 MPa, the fine pattern on the transfer stamp is not sufficiently transferred to the coated film of the photocurable resin composition, and this may cause a large area of the film layer to remain not structured and may cause the film layer to have insufficient adhesion with the substrate. When the transfer is performed in narrowly-defined nanoimprint, the cured article after transfer has a layer thickness of, for example, 50 to 1000 nm. The transfer in narrowly-defined nanoimprint should therefore be performed at a transfer pressure of 5 MPa or more, for meeting high requirements in resolution, wall slope, and aspect ratio (ratio of height to resolution) at a layer thickness of several hundred nanometers. Specifically, if the transfer pressure is less than 5 MPa, the pattern edges may tend to be round (pattern breakdown), and pattern deformation and pattern missing on the substrate may more frequently occur. In contrast, if the transfer pressure is more than 100 MPa, it may be difficult to separate the transfer stamp from the coated film, and pattern breakdown may often occur upon separation.

In broadly-defined nanoimprint, if the transfer is performed at a pressure of less than 5 MPa, the fine pattern on the transfer stamp is not sufficiently transferred to the coated film of the photocurable resin composition, and this may cause a large area of the coated film to remain not structured and may cause the coated film to have insufficient adhesion with the substrate (support). Additionally, if the transfer is performed at a transfer pressure of less than 5 MPa to give a diffraction type light-condensing film, the pattern is not sufficiently transferred, the resulting diffraction type light-condensing film may have taper angles of patterns of less than 44 degrees, and pattern deformation and pattern missing on the substrate may more frequently occur. In contrast, if the transfer pressure is more than 100 MPa, it may be difficult to separate the transfer stamp from the coated film, and pattern breakdown may often occur upon separation.

In Step (1), curing may be performed while the nanostamper lies stand on the film or after the nanostamper is removed. In a preferred embodiment, the process includes the steps of transferring the pattern from the nanostamper to the film by pressing the nanostamper to the film at a pressure of, for example, 5 to 100 MPa, preferably 10 to 100 MPa, and more preferably more than 10 MPa and 100 MPa or less for a duration of, for example, 0.1 to 300 seconds, preferably 0.2 to 100 seconds, and especially preferably 0.5 to 30 seconds as Step (1); and simultaneously curing the film through heating or UV irradiation to give a fine structure.

### [Step (2)]

Curing in Step (2) can be performed typically through heating and/or UV irradiation. When curing is performed through UV irradiation, heating can be performed in combination with the UV irradiation according to necessity. Typically, the film material can be cured by heating at about 80°C to 150°C for about 1 to 10 minutes and thereafter irradiated with ultraviolet rays for about 0.1 second to 2 minutes. After curing the film, the nanostamper (transfer imprint stamp) may be removed to give an imprinted fine structure.

The thickness of the cured film after curing is typically about 50 to 1000 nm, and preferably about 100 to 500 nm when the film is formed by narrowly-defined nanoimprint, and is typically about 0.1 µm to 10 mm, and preferably about 1 µm to 1 mm when the film is formed by broadly-defined nanoimprint.

Observation of the resulting fine structure with a scanning electron microscope reveals that the target substrate has not only the imprinted fine structure but also a residual layer. The residual layer is derived from the film not structured and has a thickness of less than 30 nm. When the substrate with the fine structure is subsequently used in microelectronics, the residual layer should be removed for achieving a steep wall slope and a high aspect ratio.

### [Step (3)]

Accordingly, the process for production of a fine structure of the present invention preferably includes Step (3) of etching the cured film. The fine structure can be etched typically with oxygen plasma or a gaseous mixture of CHF₃ and O₂.

When the production process is adopted to the production of a semiconductor material, whose support is structured by Steps (1) and (2), the production process preferably further includes the step of doping the semiconductor material in the etched areas; and/or the step of etching the semiconductor material. This production process is effective for the production of a finely structured semiconductor material.

After etching, the resist coating can be removed with a common solvent such as tetramethylammonium hydroxide.

Cationically curable monomers have advantages of (i) shrinking little on curing and (ii) being not inhibited with oxygen; but have disadvantages typically of (i) having low reaction rates and (ii) being largely affected typically by alkalis (bases). In contrast, free-radically curable monomers have advantages typically of (i) being highly stable during storage, (ii) having high polymerization rates, (iii) being less affected typically by water (moisture), (iv) being capable of giving thick films through curing, and (v) having large variation in monomer type; but have disadvantages typically of (i) shrinking largely on curing, (ii) suffering from inhibition with oxygen, and (iii) showing significant odor and skin irritation.

The photocurable resin compounds for use in the present invention preferably include a cationically polymerizable compound which is expandable upon curing (setting expandability). When containing a large amount of this compound, the photocurable resin compounds can give an ideal photocurable resin composition for nanoimprint which does not at all suffer from volumetric shrinkage, whose shrinkage on curing is controlled or suppressed. However, the resulting photocurable resin composition as intact is desired to have further higher adhesion with the substrate. Such sufficient adhesion with the substrate can be obtained according to the present invention by employing the process for the production of a fine structure, in which the pattern is transferred at a transfer pressure in the range of 5 MPa or more and 100 MPa or less.

The process for production of a fine structure according to an embodiment of the present invention gives a fine structure by forming a film from a resin composition containing a cationically curable monomer and transferring a pattern to the film at a transfer pressure in the range of 5 MPa or more and 100 MPa or less. The resulting fine structure excels in pattern shape and pattern accuracy.

The process for production of a fine structure according to another embodiment of the present invention gives a fine structure by forming a film from a resin composition containing a free-radically curable monomer on a support and transferring a pattern to the film at a transfer pressure in the range of 5 MPa or more and 100 MPa or less. The resulting fine structure excels in pattern shape and pattern accuracy and has satisfactory resistance to shrinkage on curing, in which the shrinkage on curing, a defect of a free-radical curing system, is suppressed.

The process for production of a fine structure according to yet another embodiment of the present invention gives a fine structure by forming a film from a composition containing both a cationically curable monomer and a free-radically curable monomer on a support and transferring a pattern to the film at a transfer pressure in the range of 5 MPa or more and 100 MPa or less. The resulting fine structure excels in pattern shape and pattern accuracy and has satisfactory resistance to shrinkage on curing, in which the shrinkage on curing, a defect of a free-radical curing system, is suppressed.

The composition contains both a cationically curable monomer and a free-radically curable monomer and thus accepts a curing system through both cationic curing and free-radical curing. This curing system keeps a good balance between curing rate and shrinkage on curing. The process for production of a fine structure of the present invention, in which a pattern is transferred at a transfer pressure in the range of 5 MPa or more and 100 MPa or less, gives a fine structure which excels in pattern shape and pattern accuracy and has satisfactory resistance to shrinkage on curing, in which the shrinkage on curing, a defect of a free-radical curing system, is suppressed.

The process for production of a fine structure of the present invention can give a homogeneously patterned article having a fully uniform film in a wide area by transferring a pattern at a transfer pressure in the range of 5 MPa or more and 100 MPa or less. In addition, the process for production of a fine structure of the present invention can give a fine structure with a film thickness of less than 10 µm (e.g., 0.01 to 1 µm) which excels in pattern accuracy and has very little pattern deformation or pattern missing. The process can also give a fine structure which retains its pattern shape even when the nanostamper is separated therefrom after UV curing, which excels in pattern accuracy, and which hardly suffers from pattern deformation and pattern missing.

The process for production of a fine structure of the present invention can further give a fine structure or fine pattern on a thick film with a thickness exceeding 10 µm by transferring a pattern at a transfer pressure in the range of 5 MPa or more and 100 MPa or less. Therefore, a resist for fine structuring or fine patterning on a thick film with a thickness exceeding 50 µm, which is required to make flat screens, holograms, waveguides, precision machinery components, and sensors, may be obtained.

### EXAMPLES

The present invention will be illustrated in further detail with reference to several working examples below. It should be noted, however, that these examples are never construed to limit the scope of the present invention.

### SYNTHESIS EXAMPLE 1

### Nanoscale Particle Dispersion (E-1)

Acryloyloxypropyltrimethoxysilane (GPTS) (236.1 g; 1 mol) was refluxed with water (26 g; 1.5 mol) for 24 hours. Methanol generated by the reflux was removed at 70°C using a rotary evaporator to obtain a GPTS condensate.
To the GPTS condensate was added 345 g of zirconium oxide (ZrO₂ having an average particle diameter of 20 nm, and dispersed in methyl ethyl ketone with a ZrO₂ concentration of about 5 percent by weight; supplied by Kitamura Chemicals Co., Ltd.) with stirring, and thereby yielded a nanoscale particle dispersion (E-1).

### EXAMPLES 1 to 16 and COMPARATIVE EXAMPLES 1 to 3

### 1) Preparation Method of Coated Film

### <Silicon Substrate>

A silicon substrate used herein was a 25-mm square silicon wafer which had been pre-treated with hexamethyldisilazane.

### <Photocurable Resin Composition for Nanoimprint>

A series of photocurable resin compositions for nanoimprint was prepared in a spin coater according to a known procedure using the cationically curable monomer (A), free-radically curable monomer (B), initiator (C), sensitizer (D), nanoscale particle (E), binder resin (film-forming aid; F), and solvent (G) as given in Table 1. Specific compounds as the respective components in Table 1 are shown below.

### Cationically Curable Monomers

A-1: 3,4-Cyclohexylmethyl-3,4-cyclohexanecarboxylate; CELLOXIDE 2021P (CEL2021P) supplied by Daicel Chemical Industries, Ltd.
A-2: 1,4-Bis[(3-ethyl-3-oxetanylmethoxy)methyl]benzene n=1; OXT-121 supplied by Toagosei Co., Ltd.
A-3: Triethylene glycol divinyl ether; product supplied by Maruzen Petrochemical Co., Ltd.
A-4: 3,3-Bis(vinyloxymethyl)oxetane; article developed by Daicel Chemical Industries, Ltd.
A-5: Bicyclohexyl diepoxide; CELLOXIDE 8000 (CEL8000) supplied by Daicel Chemical Industries, Ltd.

### Free-Radically Curable Monomers

B-1: Adduct of acrylic acid with lactone; M5300 supplied by Toagosei Co., Ltd.
B-2: Trimethylolpropane triacrylate; product supplied by Daicel-Cytec Co., Ltd.
B-3: Tetraethylene glycol diacrylate; product supplied by Kyoeisha Chemical Co., Ltd.

### Initiators

C-1: 4-Methylphenyl[4-(1-methylethyl)phenyliodonium tetrakis(pentafluorophenyl)borate; PI2074 supplied by Rhodia
C-2: 2,2-Dimethoxy-1,2-diphenylethan-1-one; Irgacure 651 supplied by Ciba Japan (now part of BASF Japan Ltd.) Sensitizers
D-1: Dibutoxyanthracene; DBA supplied by Kawasaki Kasei Chemicals Ltd.

### Nanoscale particles

E-1: Nanoparticle dispersion prepared in Synthesis Example 1

### Film-Forming Aids (Binder Resins)

F-1: Copolymer of 3,4-epoxycyclohexylmethyl acrylate (CYCLOMER A400 supplied by Daicel Chemical Industries, Ltd.) and 1-ethyl-3-oxetanylmethyl methacrylate (product supplied by Toagosei Co., Ltd.)
F-2: Polyacrylate having free-radically polymerizable vinyl groups in the side chains; CYCLOMER P (ACA300) supplied by Daicel Chemical Industries, Ltd.

### Solvents

G-1: Propylene glycol monomethyl ether acetate; MMPGAC supplied by Daicel Chemical Industries, Ltd.

### <Preparation of Coated Film>

The compositions for nanoimprint were respectively formed into films coated on the silicon wafer through spin coating (at 3000 rpm, for 30 seconds). In the case of a composition containing a solvent, the coated film was dried at about 95°C for 5 minutes to remove the solvent. The dry coated film after drying had a layer thickness of about 500 nm.

### 2) Transfer and Imprinting of Fine Structure onto Target Substrate

A fine structure was transferred and imprinted onto the target substrate with an imprinter (Model NM-0403 supplied by Meisho Kiko Co.). This imprinter is a computer-controlled test machine which makes it possible to program, for example, loading and relief speeds and heating temperature and to maintain defined pressures over a specific time. With an attached high-pressure mercury lamp, the imprinter performs UV irradiation to start curing photochemically.

### <Patterning of Fine Structure>

Specifically, the silicon wafer, on which the coated film of the composition for nanoimprint was prepared according to the above-mentioned spin coating procedure, was placed on a stage. Next, a quartz mold having a finely pattern was placed on the coated film, and the pattern was transferred while increasing the transfer pressure to a predetermined pressure over 30 seconds. While maintaining the transfer pressure, UV irradiation was performed through the quartz mold to thereby cure the composition. The transfer pressures (pressing pressures) adopted in Examples 1 to 16 and Comparative Examples 1 to 3 are shown in Table 1.

Other conditions, i.e., the pressing temperatures, pressing times, and UV exposures adopted in Examples 1 to 16 and Comparative Examples 1 to 3 are also shown in Table 1.
A 200-nm line-and-space pattern was transferred respectively in Examples 1 to 16 and Comparative Examples 1 to 3. After imprinting, the nanostamper was removed, and a nanostructure including a silicon wafer bearing a pattern thereon was obtained. A residual film of the pattern was subjected to plasma etching with oxygen, further subjected to dry etching with CHF₃/O₂ (25:10 (ratio by volume)) and thereby yielded the silicon wafers with the fine structure patterns.

### <Evaluation of Fine Patterning>

The fine structure patterns prepared according to Examples 1 to 16 and Comparative Examples 1 to 3 were evaluated on shape and accuracy by methods mentioned below. The results are shown in Table 1.

### (Pattern Shape of Fine Structure)

Each shape of the fine structure patterns on the silicon wafers after dry etching was observed with a scanning electron microscope, and whether or not traces in the pattern have rectangular edge shapes was evaluated according to the following criteria:
A: Trace edges were rectangular shapes.
B: Trace edges were rounded to some extent.
C: Trace edges were rounded, namely, pattern breakdown occurred.

### (Pattern Accuracy of Fine Structure)

After imprinting, the nanostamper was removed to obtain a pattern (with traces) on the silicon wafer. Of such traces, 1-µm square traces were evaluated according to the following criteria:
AA: Trace deformation and/or trace missing was observed on the silicon wafer at one point or less.
A: Trace deformation and/or trace missing was observed on the silicon wafer at more than one but ten or less points.
C: Trace deformation and/or trace missing was observed on the silicon wafer at more than ten points.

### [Table 1]

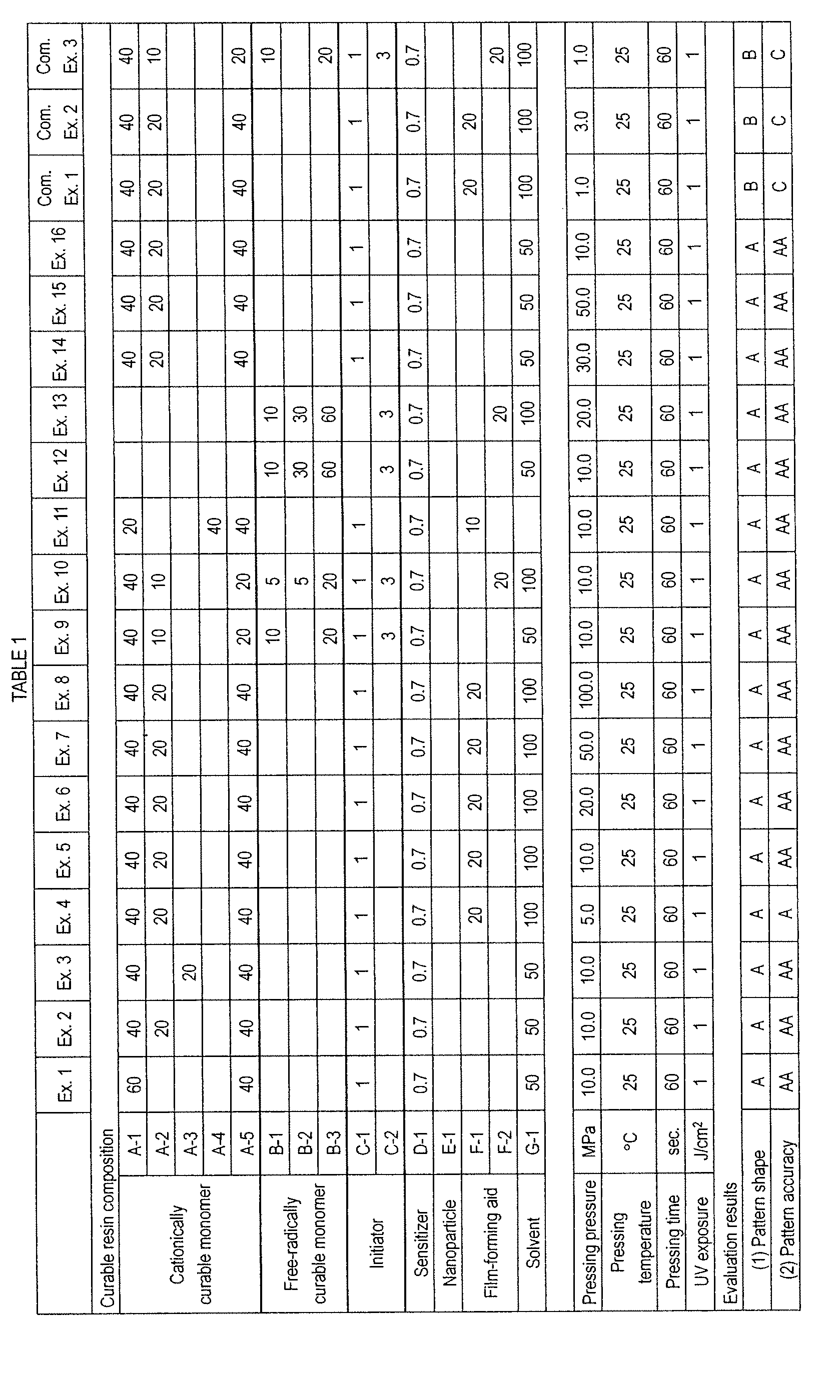

The amounts of the respective components in the curable resin compositions in Table 1 are indicated by part(s) by weight.

In Examples 1 to 8, 11, and 14 to 16, fine structures were obtained by forming films from photocurable resin compositions for nanoimprint including cationically curable compositions; transferring patterns to the films at transfer pressures of 5.0, 10.0, 20.0, 30.0, 50.0, and 100.0 MPa, respectively, whereby patterning the films; and curing the patterned films. Each of these cationically curable compositions contained 40 parts by weight of a setting-expandable compound (A-5: bicyclohexyl diepoxide) and gave fine structures excellent in pattern shape, in which the pattern edges remained rectangular. Regarding the pattern accuracy, the structures formed at transfer pressures in the range of 10.0 to 100.0 MPa showed excellent pattern accuracy, in which pattern deformation and pattern missing on the silicon wafers was observed at one point or less. Even the structure formed at a transfer pressure of 5.0 MPa showed good pattern accuracy, in which pattern deformation and/or pattern missing was observed on the silicon wafer at more than one but ten or less points.

In contrast, in Comparative Examples 1 and 2, fine structures were obtained in the same manner as in the examples above, by forming films from photocurable resin compositions for nanoimprint including cationically curable monomers; transferring patterns to the films at transfer pressures of 1.0 and 3.0 MPa, respectively, whereby patterning the films; and curing the patterned films. These photocurable resin compositions each contained 40 parts by weight of the setting-expandable compound (A-5: bicyclohexyl diepoxide) as in the examples above. The resulting fine structures were inferior both in pattern shape and in pattern accuracy, in which the pattern edges were rounded to some extent, and pattern deformation and pattern missing were observed on the silicon wafers each at more than ten points.

According to Examples 9 and 10, fine structures were obtained by forming films from photocurable resin compositions for nanoimprint including both cationically curable monomers and free-radically curable monomers; transferring patterns to the films at a transfer pressure of 10.0 MPa, whereby pattering the films; and curing the patterned films. The resulting fine structures were good in pattern shape, in which the pattern edges remained rectangular. In addition, they were excellent in pattern accuracy, in which pattern deformation and/or pattern missing was observed on the silicon wafers at one point or less, respectively.

In contrast, according to Comparative Example 3, a fine structure was obtained by forming a film from a photocurable resin composition for nanoimprint including both cationically curable monomers and free-radically curable monomers; transferring a pattern to the film at a transfer pressure of 1.0 MPa, whereby pattering the film; and curing the patterned film. The resulting fine structure was inferior both in pattern shape and in pattern accuracy, in which the pattern edges were rounded to some extent, and pattern deformation and pattern missing were observed on the silicon wafer at more than ten points.

According to Examples 12 and 13, fine structures were obtained by forming films from photocurable resin compositions for nanoimprint including free-radically curable monomers; transferring patterns to the films at transfer pressures of 10.0 MPa and 20.0 MPa, respectively, whereby pattering the films; and curing the patterned films. The resulting fine structures were good in pattern shape, in which the pattern edges remained rectangular. In addition, they were excellent in pattern accuracy, in which pattern deformation and/or pattern missing was observed on the silicon wafers at one point or less, respectively.

### EXAMPLES 17 to 30 and COMPARATIVE EXAMPLES 4 to 6

### <Production of Diffraciton Type Light-condensing Films>

A series of photocurable resin compositions for nanoimprint was prepared by mixing the cationically curable monomer (A), free-radically curable monomer (B), initiator (C), sensitizer (D), nanoscale particles (E), binder resin (film-forming aid; F), and solvent (G) in types and amounts given in Table 2. The components in Table 2 are as with those in Table 1, except for the following components.

### Free-Radically Curable Monomer

B-4: Methyl methacrylate

### Film-Forming Aid

F-11: Copolymer of 3,4-epoxycyclohexylmethyl acrylate (CYCLOMER A400 supplied by Daicel Chemical Industries, Ltd.) and 1-ethyl-3-oxetanylmethyl methacrylate (product supplied by Toagosei Co., Ltd.)
F-12: Epoxidized polybutadiene; EPOLEAD PB3600 (EPL PB3600) supplied by Daicel Chemical Industries, Ltd.
F-13: Polyacrylic ester having free-radical polymerizable vinyl groups in its side chains; CYCLOMER P (ACA300) supplied by Daicel Chemical Industries, Ltd.

A mold for diffraction type light-condensing film was used as a nanostamper. The mold was a small-sized mold (supplied by Toshiba Machine Co., Ltd.) made from Ni-P, having a pattern with a pitch of 5 µm, a height of 5.7 µm, and a taper angle of 45 degrees, and having a grating pattern 2 cm long and 1 cm wide. Coated films were formed respectively from the resin compositions on the mold for diffraction type light-condensing film. In the case of a composition containing a solvent, the coated film was dried (prebaked) at about 95°C for 5 minutes to remove the solvent. A support film (made from PET, supplied by Toyobo Co. Ltd. under the trade name "A4300", 75 µm thick) was placed on the coated films, and the resulting articles were planarized by applying a predetermined pressure thereon using a roller.

The prepared laminates of (mold)/(coated film)/(support film) was exposed to light to cure the resin compositions. The exposure was performed using an ultrahigh-pressure mercury lamp (Model USH-3502MA supplied by Ushio Inc., with an illuminance of 16 mW/cm²) at an accumulated exposure of 1 J/cm². After the completion of curing, the laminates of the coated film and the support film were separated from the molds and thereby yielded a series of diffraction type light-condensing films. The pressing pressures, pressing temperatures, and UV exposures adopted in Examples 17 to 30 and Comparative Examples 4 to 6 for the preparation of the diffraction type light-condensing films are shown in Table 2.

The diffraction type light-condensing films prepared according to Examples 17 to 30 and Comparative Examples 4 to 6 were evaluated on transferability (pattern shape), pattern accuracy, and refractive index by methods mentioned below. The results are shown in Table 2.

### <Evaluation Methods>

### (Pattern Shape)

How the pattern shape was transferred (transferability) was evaluated by observing the taper angles of patterns of a sample diffraction type light-condensing film with a reflecting microscope (metalloscope). The evaluation criteria are as follows:
A: Satisfactory transfer (taper angles: 45 degrees)
B: Insufficient transfer (taper angles: 40 to 44 degrees)
C: Inferior transfer

### (Pattern Accuracy)

After the completion of curing, the laminate of the coated film and support film was separated form the mold, and, of traces formed on the support film, 1-µm square traces were evaluated according to the following criteria.
AA: Pattern deformation and/or pattern missing was observed on the support film at one point or less.
A: Pattern deformation and/or pattern missing was observed on the support film at more than one but ten or less points.
C: Pattern deformation and/or pattern missing was observed on the support film at more than ten points.

### (Refractive Index)

A series of cured articles was prepared through UV curing from the photocurable resin compositions used in Examples 17 to 30 and Comparative Examples 4 to 6, and refractive indices of the cured articles were measured with an Abbe refractometer, respectively.

### [Table 2]

**TABLE 2**

| | | Ex. 17 | Ex. 18 | Ex. 19 | Ex. 20 | Ex. 21 | Ex. 22 | Ex. 23 | Ex. 24 | Ex. 25 | Ex. 26 | Ex. 27 | Ex. 28 | Ex. 29 | Ex. 30 | Com. Ex. 4 | Com. Ex. 5 | Com. Ex. 6 |
|---|---|---|---|---|---|---|---|---|---|---|---|---|---|---|---|---|---|---|
| Curable resin composition | | | | | | | | | | | | | | | | | | |
| Cationically curable monomer | A-1 | 60 | 40 | 60 | 40 | 40 | 40 | 20 | 20 | 20 | | 20 | 20 | 20 | | 40 | 40 | 20 |
| | A-2 | | 20 | 20 | 20 | | | | | | | 20 | | | | 20 | 20 | 20 |
| | A-3 | | | | | 20 | | | | | | | | | | | | |
| | A-4 | | | | | | 20 | 40 | 40 | 40 | | | 20 | 20 | | | | |
| | A-5 | 40 | 40 | 40 | 40 | 40 | 40 | 40 | 40 | 40 | | 20 | 20 | 20 | | 40 | 40 | 20 |
| Free-radically curable monomer | B-1 | | | | | | | | | | 10 | | | | | | | |
| | B-2 | | | | | | | | | | 30 | 10 | 10 | 10 | | | | 10 |
| | B-3 | | | | | | | | | | 60 | 30 | 30 | 30 | 20 | | | 30 |
| | B-4 | | | | | | | | | | | | | | 20 | | | |
| Initiator | C-1 | 1 | 1 | 1 | 1 | 1 | 1 | 1 | 1 | 1 | | 1 | 1 | 1 | 1 | 1 | 1 | 1 |
| | C-2 | | | | | | | | | | 3 | 3 | 3 | 3 | | | | 3 |
| Sensitizer | D-1 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 | 0.7 |
| Nanoparticles | E-1 | | | | | | | | 10 | 10 | | | | | | | | |
| Film-forming aid | F-11 | | 20 | 20 | 20 | | | | 10 | | | | | | | 20 | 20 | |
| | F-12 | | | | | | | | | 10 | | | | | | | | |
| | F-13 | | | | | | | | | | 20 | | | | | | | 20 |
| Solvent | G-1 | | 20 | 20 | 20 | | | | | | 20 | | | | | 20 | 20 | 20 |
| | | | | | | | | | | | | | | | | | | |
| Pressing pressure | MPa | 5.0 | 5.0 | 20.0 | 100.0 | 10.0 | 10.0 | 10.0 | 10.0 | 10.0 | 10.0 | 10.0 | 10.0 | 10.0 | 10.0 | 1.0 | 3.0 | 1.0 |
| Pressing temperature | °C | 25 | 25 | 25 | 25 | 25 | 25 | 25 | 25 | 25 | 25 | 25 | 25 | 25 | 25 | 25 | 25 | 25 |
| UV exposure | J/cm² | 1 | 1 | 1 | 1 | 1 | 1 | 1 | 1 | 1 | 1 | 1 | 1 | 1 | 1 | 1 | 1 | 1 |
| Evaluation results | | | | | | | | | | | | | | | | | | |
| (1) Pattern shape | | A | A | A | A | A | A | A | A | A | A | A | A | A | A | B | B | B |
| (2) Pattern accuracy | | A | AA | AA | AA | AA | AA | AA | AA | AA | AA | AA | AA | AA | AA | C | C | C |
| (3) Refractive index | | 1.54 | 1.53 | 1.53 | 1.53 | 1.54 | 1.54 | 1.54 | 1.6 | 1.6 | 1.51 | 1.53 | 1.52 | 1.52 | 1.56 | 1.53 | 1.53 | 1.53 |

The amounts of the respective components in the curable resin compositions in Table 2 are indicated by part(s) by weight.

Table 2 demonstrates as follows. The UV-cured articles prepared according to Examples 17 to 30 show high refractive indices and are effective as diffraction type light-condensing films.

According to Examples 17 to 25, diffraction type light-condensing films were prepared from photocurable resin compositions for nanoimprint containing different cationically curable compositions at transfer pressures of 5.0, 10.0, 20.0, and 100.0 MPa.

The resulting diffraction type light-condensing films had patterns of good shapes with taper angles of 45 degrees. The diffraction type light-condensing films showed excellent pattern accuracy, in which pattern deformation and/or pattern missing was observed on the support film at one point or less. Even the structure formed at a transfer pressure of 5.0 MPa showed good pattern accuracy, in which pattern deformation and/or pattern missing was observed on the support film at more than one but ten or less points or at one point or less.

In contrast, according to Comparative Examples 4 and 5, diffraction type light-condensing films were prepared from photocurable resin compositions for nanoimprint containing cationically curable monomers at transfer pressures of 1.0 and 3.0 MPa, respectively. The resulting films were inferior both in pattern shape and in pattern accuracy. Specifically, they had taper angles of 40 to 44 degrees, demonstrating insufficient transfer, and pattern deformation and pattern missing was observed on the support films each at more than ten points.

According to Examples 27 to 29, diffraction type light-condensing films were prepared from photocurable resin compositions for nanoimprint containing both cationically curable monomers and free-radically curable monomers at a transfer pressure of 10.0 MPa. The resulting films had satisfactory pattern shapes with taper angles of 45 degrees and showed excellent pattern accuracy, in which pattern deformation and/or pattern missing was observed on the support film at one point or less.

In contrast, according to Comparative Example 6, a diffraction type light-condensing film was prepared from a photocurable resin composition for nanoimprint containing both cationically curable monomers and free-radically curable monomers at a transfer pressure of 1.0 MPa. The resulting film was inferior both in pattern shape and in pattern accuracy, as the film had taper angles of 40 to 44 degrees, and pattern deformation and/or pattern missing was observed on the support film at more than ten points.

According to Examples 26 and 30, diffraction type light-condensing films were prepared from photocurable resin compositions for nanoimprint containing free-radically curable monomers at a transfer pressure of 10.0 MPa. The resulting films had satisfactory pattern shapes with taper angles of 45 degrees and showed excellent pattern accuracy, in which pattern deformation and/or pattern missing was observed on the support film at one point or less.

### Industrial Applicability

The process for forming a fine pattern of the present invention can highly accurately produce fine structures typically of electronic components and optical components which show low line edge roughness and are more economical. The process is therefore very useful typically in semiconductor materials, flat screens, holograms, diffraction type light-condensing films, waveguides, structures for media, precision machinery components or sensors, and other precision machinery components.

## Claims

1. A process for production of a fine structure through nanoimprinting on a photocurable resin composition, the process comprising the steps of:
(1) forming a photocurable resin composition for nanoimprint into a film on a support and transferring a pattern to the film by pressing the film with a nanostamper at a pressure in a range of 5 to 100 MPa, wherein the photocurable resin composition contains a curable compound component including a cationically polymerizable compound and/or a free-radically polymerizable compound; and
(2) curing the patterned film to obtain the fine structure.

2. A fine structure produced by the process of claim 1.

3. The fine structure of claim 2, being a semiconductor material, a flat screen, an optical member, a hologram, a waveguide, a structure for media, a precision machinery component, or a sensor.
